Europäisches Patentamt

European Patent Office

Office européen des brevets

(19)

(11) **EP 1 516 159 B1**

(12) **EUROPÄISCHE PATENTSCHRIFT**

(45) Veröffentlichungstag und Bekanntmachung des Hinweises auf die Patenterteilung:
**30.11.2005 Patentblatt 2005/48**

(21) Anmeldenummer: **03760584.7**

(22) Anmeldetag: **29.04.2003**

(51) Int Cl.⁷: **G01D 5/16**, G01L 19/04, G01R 33/09, H02P 6/00

(86) Internationale Anmeldenummer:
**PCT/EP2003/004436**

(87) Internationale Veröffentlichungsnummer:
**WO 2004/001341 (31.12.2003 Gazette 2004/01)**

(54) **TEMPERATURKOMPENSATION EINER SENSORANORDNUNG (GMR) MIT BEIDSEITIGEN POTENTIAL NDERUNGEN**

TEMPERATURE COMPENSATION OF A SENSOR ARRANGEMENT (GMR) WITH DOUBLE-SIDED POTENTIAL CHANGES

COMPENSATION DE LA TEMPERATURE D'UN DISPOSITIF DE DETECTION (GMR) AVEC DES MODIFICATIONS DE POTENTIEL BILATERALES

(84) Benannte Vertragsstaaten:
**DE FR GB IT**

(30) Priorität: **24.06.2002 DE 10228023**

(43) Veröffentlichungstag der Anmeldung:
**23.03.2005 Patentblatt 2005/12**

(73) Patentinhaber: **ebm-papst St. Georgen GmbH & Co. KG**
**78112 St. Georgen (DE)**

(72) Erfinder:
• **PFAFF, Andreas**
**78141 Schönwald (DE)**
• **RUDEL, Christian**
**78126 Königsfeld (DE)**

(74) Vertreter: **Raible, Hans**
**Raible & Raible**
**Patentanwälte**
**Schoderstrasse 10**
**70192 Stuttgart (DE)**

(56) Entgegenhaltungen:
**WO-A-02/03089**　　　　**DE-A- 19 531 386**
**DE-A- 19 619 806**　　　　**US-A- 4 202 218**
**US-A- 4 510 813**　　　　**US-A- 5 253 532**

• **STEFAN KEIL: "Beanspruchungsermittlung mit Dehnungsmesstreifen Seiten 190-198 mit drei Hilfsseiten" 1995 , CUNEUS , ZWINGENBERG (DE) XP002249939 Seite 192, Zeile 1 - Zeile 16; Abbildungen 195,197**

EP 1 516 159 B1

**Beschreibung**

Die Erfindung betrifft ein Verfahren zur Temperaturkompensation einer Sensoranordnung. Sie betrifft ferner eine temperaturkompensierte Sensoranordnung mit einer Brückenschaltung.

Eine derartige Sensoranordnung liefert im Betrieb mindestens ein Ausgangssignal, das von einer zu messenden Größe abhängig ist, z.B. von der Helligkeit einer Lichtquelle, von der Richtung eines Magnetfeldes, etc. Unter einer Brückenschaltung wird hierbei eine Halb- oder Vollbrücke verstanden.

Bei einer solchen Sensoranordnung ist wünschenswert, dass unabhängig von der augenblicklichen Betriebstemperatur der Brückenschaltung einer bestimmten zu messenden Größe, z.B. einem Magnetfeld mit einer Richtung von 90°, stets dasselbe Ausgangssignal der Sensoranordnung entspricht, z.B. +3,4 V.

Wenn der Gesamtwiderstand einer Brückenschaltung mit steigender Betriebstemperatur zunimmt, so nimmt ihre Ausgangsspannung mit steigender Temperatur ab, sofern nicht die Speisespannung der Brückenschaltung kompensatorisch verändert, also erhöht wird. Umgekehrt muss in einem solchen Fall die Speisespannung mit fallender Betriebstemperatur entsprechend reduziert werden, damit die Ausgangsspannung konstant bleibt.

Es ist deshalb eine Aufgabe der Erfindung, ein neues Verfahren zur Temperaturkompensation einer Sensoranordnung, sowie eine neue Sensoranordnung der genannten Art, bereit zu stellen.

Nach der Erfindung wird diese Aufgabe gelöst durch das Verfahren des Patentanspruchs 1.

Hierdurch erreicht man, dass bei einer Änderung der Betriebstemperatur der Brückenschaltung sich das Potenzial an deren erstem Eingang in einem ersten Sinne ändert, und dass sich das Potenzial an deren zweitem Eingang in einem zum ersten Sinn entgegengesetzten zweiten Sinn ändert. Das kann z.B. bedeuten, dass bei einem bestimmten Temperaturanstieg das Potenzial am ersten Eingang um 0,1 V zunimmt, und das Potenzial am zweiten Eingang um 0,1 V abnimmt, wobei die Änderungen vorzugsweise so bemessen sind, dass das Ausgangssignal praktisch unverändert bleibt, solange sich die zu messende Größe nicht ändert.

Eine weitere Lösung der gestellten Aufgabe ergibt sich durch den Gegenstand des Patentanspruchs 4.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den Unteransprüchen. Es zeigt:

Fig. 1     eine zweipolige Magnetscheibe 20, die im Betrieb in Richtung eines Pfeiles 22 rotiert und über der ein sogenannter GMR-Sensor 39 angeordnet ist, mit dem die Richtung phi eines von der Scheibe 20 im Sensor 39 erzeugten magnetischen Flusses M erfasst wird,

Fig. 2     einen Schnitt, gesehen längs der Linie II-II der Fig. 1, welcher zeigt, dass der GMR-Sensor 39 im Abstand von der Scheibe 20 angeordnet ist,

Fig. 3     ein schematische Darstellung zur Erläuterung der Wirkungsweise eines Elements eines GMR-Sensors,

Fig. 4     eine schematische Darstellung des inneren Aufbaus eines Elements eines GMR-Sensors,

Fig. 5     eine Darstellung von zwei Halbbrücken 40, 42 eines GMR-Sensors einer bestimmten Bauart,

Fig. 6     eine stark schematisierte Ubersichtsdarstellung zur Erläuterung der Grundzüge der Erfindung,

Fig. 7     ein Schaltbild gemäß einer bevorzugten Ausführungsform der Erfindung,

Fig. 8     eine schematische Darstellung zur Erläuterung von Fig. 7,

Fig. 9     ein Oszillogramm von zwei Messspannungen, die von einem temperaturkompensierten GMR-Sensor geliefert werden, und

Fig. 10    eine Variante zu Fig. 7 mit einem NIC (Negative Impedance Converter).

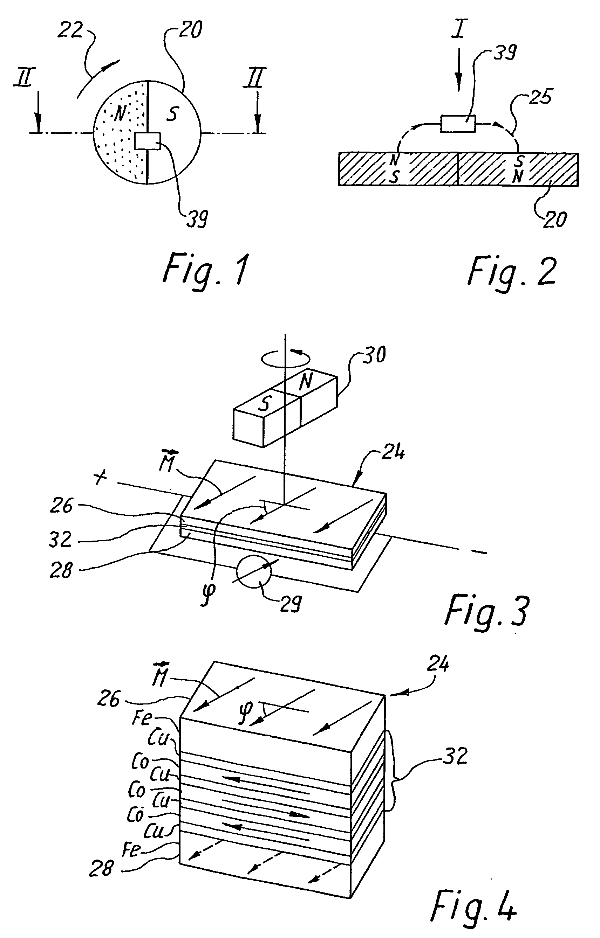

**Fig. 1** zeigt eine zweipolige Magnetscheibe 20, welche im Betrieb in Richtung eines Pfeiles 22 rotiert und über der ein Sensor 39 angeordnet ist. **Fig. 2** zeigt einen gegenüber Fig. 1 vergrößerten Schnitt, gesehen längs der Linie II - II der Fig. 1. Man erkennt, wie der Sensor 39 in einem kleinen Abstand oberhalb der Magnetscheibe 20 angeordnet ist. Bei 25 ist eine magnetische Feldlinie angedeutet, und man sieht, dass der Sensor 39 in einem homogenen Magnetfeld angeordnet ist. Er dient dazu, die Richtung des Magnetfelds zu erfassen, und man bezeichnet ihn als GMR-Sensor (GMR = Giant Magneto Resistor).

**GMR-Sensoren**

Die **Fig. 3 und 4** dienen zur Erläuterung eines GMR-Sensors, wie er bei der vorliegenden Erfindung bevorzugt Anwendung findet.

Magnetfeldsensoren nach Art von Hallsensoren sind sehr gut geeignet für kontaktlose Messungen, also Positionserfassung, Abstands-, Geschwindigkeits- und Drehzahlmessungen, Messungen der Drehrichtung, sowie Messungen von Strömen und Leistungen. Hallsensoren erlauben auch noch unter schwierigen Bedingungen (Tau, Schmutz, extreme Temperaturen etc.) genaue Messungen. Jedoch haben sie gegenüber GMR-Sensoren einen Nachteil: Da herkömmliche Hallsensoren auf die Stärke des Magnetfeldes reagieren, sind sie sehr empfindlich gegenüber Schwankungen des Abstands zwischen Sensor und Magnet. In manchen Fällen möchte man jedoch ein Signal erhalten, das zuverlässig nur von der Richtung, nicht aber von der Stärke eines Magnetfeldes abhängt.

Aus diesem Grunde wurden die GMR-Sensoren speziell für Positionsanwendungen entwickelt, weil sie nur die Richtung der Magnetfeldlinien, nicht aber die Intensität des magnetischen Flusses messen, was relativ große Messabstände bis zu 25 mm ermöglicht. Dies erleichtert die Montage dieser Sensoren und ihre Justierung, und macht die Massenproduktion kostengünstiger. Ein weiterer Vorteil ist die Baugröße der GMR-Sensoren. Bei dem Typ GMR_C6, wie er dem nachfolgend beschriebenen Ausführungsbeispiel zugrundeliegt, befindet sich dieser Sensor in einem 6 Pin Gehäuse mit Maßen von nur 2,9 x 1,3 x 1,1 mm.

**Fig. 3** zeigt das Grundprinzip eines Elements 24 eines GMR-Sensors. Dieses Element 24 hat zwei weichferromagnetische Deckschichten 26, 28, in denen ein benachbarter Dauermagnet 30 einen Magnetfluss M mit einer Richtung phi (Fig. 4) erzeugt, die von der augenblicklichen Drehstellung dieses Dauermagneten 30 abhängt.

Zwischen den Deckschichten 26, 28 befindet sich ein Schichtstapel 32 mit fester Magnetisierung. Wie aus Fig. 4 hervorgeht, alternieren im Schichtstapel 32 mehrere Schichten Co aus Kobalt und Cu aus Kupfer. Die Dicke der einzelnen Schichten ist äußerst gering und liegt im Bereich weniger Nanometer. Das nichtmagnetische Kupfer trennt die Eisen- und Kobaltschichten in der dargestellten Weise. Durch die sehr dünnen Trennschichten werden die Kobaltschichten zu einem künstlichen "Antiferromagneten" gekoppelt. Die hartferromagnetischen Kobaltschichten Co sind in der in Fig. 4 dargestellten Weise alternierend fest magnetisiert.

Wenn ein äußeres Magnetfeld vorhanden ist, z.B. in Fig. 3 das Magnetfeld des Dauermagneten 30, richtet sich der magnetische Fluss M in den Deckschichten 26, 28 (aus weichferromagnetischem Eisen) gemäß diesem äußeren Magnetfeld aus, wogegen die hartferromagnetischen Kobaltschichten Co ihre feste Magnetisierung beibehalten. Bei gleicher magnetischer Ausrichtung der weich- und hartferromagnetischen Schichten erreicht der Widerstand sein Minimum. Bei entgegengesetzter Ausrichtung erreicht der Widerstand sein Maximum. Dadurch ist der GMR-Effekt unabhängig von der Stromrichtung durch dieses Element 24. Nur der Winkelunterschied der Magnetflüsse zwischen den weich- und hartferromagnetischen Schichten bestimmt seinen Gesamtwiderstand. Deshalb hängt dieser Widerstand allein von der Richtung phi des von außen zugeführten Magnetflusses M ab, und nicht von dessen Größe.

Um einen "Grundwiderstand" Ro von ca. 700 Ω zu erreichen, werden mäanderförmige Strompfade in das Schichtensystem geätzt. Mit einem Messinstrument 29 (Fig. 3) kann man den Widerstandswert dieses Schichtensystems messen. Dabei ergibt sich der Grundwiderstand Ro, z.B. 700 Ohm, und wenn der Magnet 30 gedreht wird, ändert sich Ro um einen Betrag AR, was ebenfalls mit dem Instrument 29 gemessen werden kann.

Je nach der Richtung phi des magnetischen Flusses M in den Deckschichten 26, 28 erhält man also einen Widerstand im Bereich (Ro ± ΔR), also zwischen einem Maximum Ro + ΔR und einem Minimum Ro - ΔR.

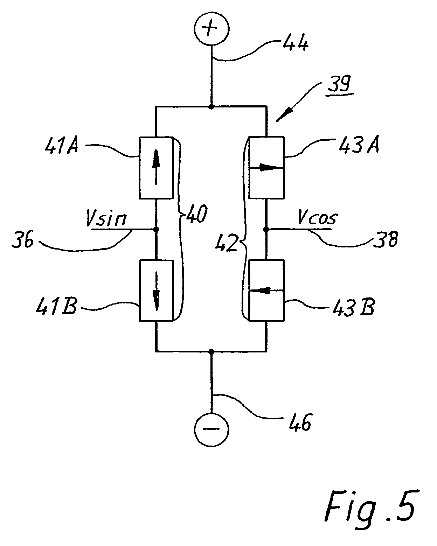

**Fig. 5** zeigt den prinzipiellen Aufbau einer GMR_C6-Brücke 39, welche zwei Halbbrücken 40, 42 aufweist. Die Halbbrücke 40 enthält zwei Sensorelemente 41 A, 41 B, deren Verbindungspunkt mit 36 bezeichnet ist und deren präferierte Flussrichtungen angegeben sind. Die Halbbrücke 42 enthält zwei Sensorelemente 43A, 43B, deren Verbindungspunkt mit 38 bezeichnet ist und deren präferierte Flussrichtungen in der angegebenen Weise unter einem rechten Winkel zu denen der Sensorelemente 41A, 41B verlaufen. Deshalb bezeichnet man eine solche Anordnung als "gekreuzte Halbbrücken" 40, 42.

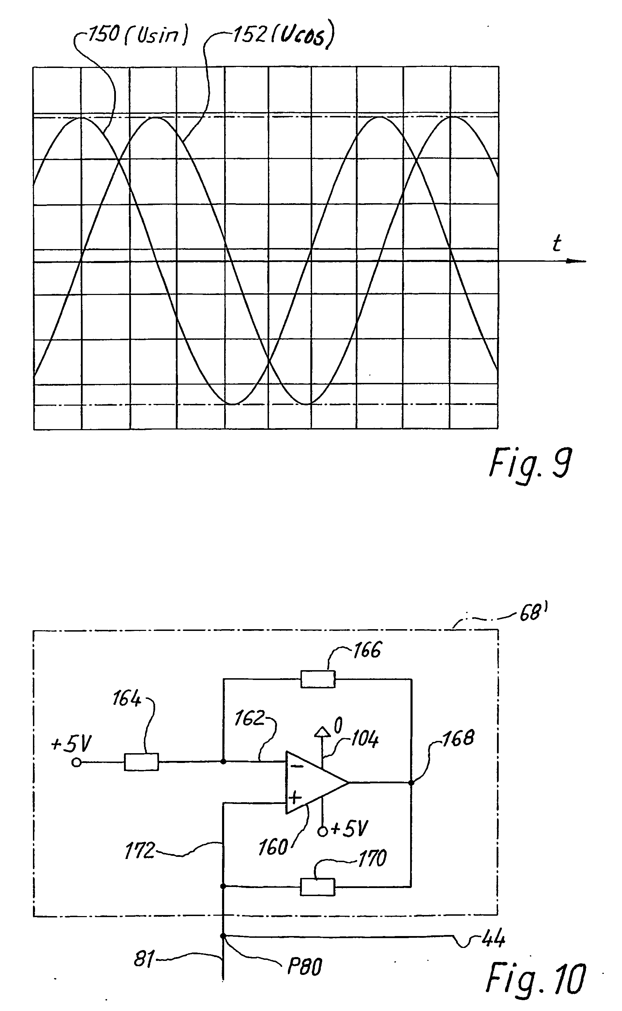

Sofern sich die Richtung phi des Magnetflusses M gleichförmig ändert, weil sich in Fig. 3 der Magnet 30 mit einer konstanten Geschwindigkeit dreht, erhält man durch den dargestellten Aufbau am Anschluss 36 eine Spannung Vsin, die sinusförmig ist, und am Anschluss 38 eine Spannung Vcos, die cosinusförmig ist, wie in Fig. 9 für Spannungen 150, 152 dargestellt. Aus den Spannungen Vsin und Vcos ergibt sich eindeutig die Richtung phi des Magnetfeldes M.

Durch interne Toleranzen kann zwischen dem Potenzial am Ausgang 36 und dem Potenzial am Ausgang 38 ein Potenzialunterschied entstehen, der beim Typ GMR_C6 lt. Datenblatt 8 mV betragen kann, wenn zwischen den Anschlüssen 44 bzw. 46 des Sensors 39 eine Betriebsspannung von 7 V angelegt wird.

GMR-Sensoren haben ein temperaturabhängiges Ausgangssignal. Mit zunehmender Temperatur steigt der Gesamtwiderstand der Brückenschaltung an, wodurch das Signal am Ausgang 36 und das Signal am Ausgang 38 sinkt. Deshalb sollte mit zunehmender Temperatur die Spannung zwischen den Eingängen 44 und 46 erhöht werden, wenn man für einen vorgegebenen Winkel phi die Spannungen an den Ausgängen 36 bzw. 38 unabhängig von der Temperatur konstant halten will.

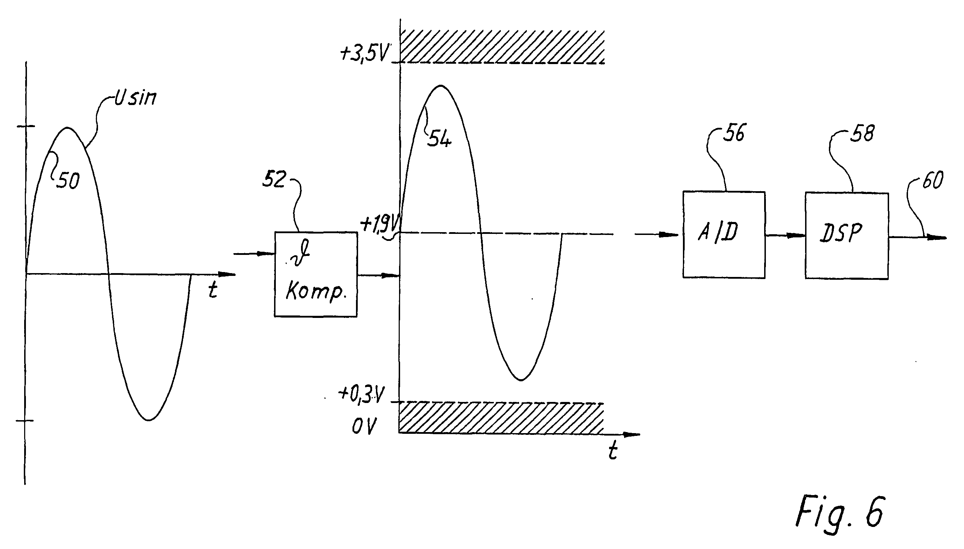

**Fig. 6** zeigt in vereinfachter und stark schematisierter Form grundlegende Überlegungen bei der vorliegenden Erfindung.

Durch den GMR-Sensor 39 (Fig. 1, 2, 5) wird das Magnetfeld der sich drehenden Magnetscheibe 20 abgetastet, und es entsteht am Ausgang 36 des Sensors 39 eine sinusförmige Spannung 50, deren positives Maximum z. B. einem Winkel phi des äußeren Magnetfelds M von 90°, deren negatives Maximum einem Winkel phi von 270° und deren Wert Null einem Winkel phi von 0°, 180° oder 360° entspricht.

Wegen der Temperaturabhängigkeit des Sensors 39 ist die Spannung 50 temperaturabhängig, und deshalb erfolgt in einer Anordnung 52 eine Temperaturkompensation, durch die diese Spannung unabhängig von der augenblicklichen Temperatur des Sensors 39 gemacht wird, und es erfolgt eine Koordinatenverschiebung in einen Spannungsbereich, der bei dem dargestellten Beispiel zwischen + 0,3 V und + 3,5 V liegt, wobei die Nulllinie, welche einem Winkel phi von 0°, 180° oder 360° entspricht, bei + 1,9 V liegt. Die koordinatenverschobene Spannung ist in Fig. 6 mit 54 bezeichnet. Naturgemäß sind die angegebenen Zahlen nur beispielhafte Werte, welche das Verständnis der Erfindung erleichtern sollen aber die Erfindung in keiner Weise beschränken.

Die Spannung 54, die bei diesem Beispiel bevorzugt innerhalb des Bereichs 0,3 V bis 3,5 V liegen sollte, wird z.B. anschließend durch einen A/D-Wandler 56 digitalisiert und dann weiter verarbeitet, z.B. wie dargestellt in einem DSP-Prozessor 58. (In einem DSP-Prozessor 58 können ggf. zusätzliche Signalkorrekturen erfolgen, so dass man an seinem Ausgang 60 ein optimiertes Signal in digitalisierter Form bereit stellen kann, das in der Qualität dem Signal eines Resolvers entspricht und sehr genau die Richtung phi des Magnetfelds M am GMR-Sensor 39 widergibt.)

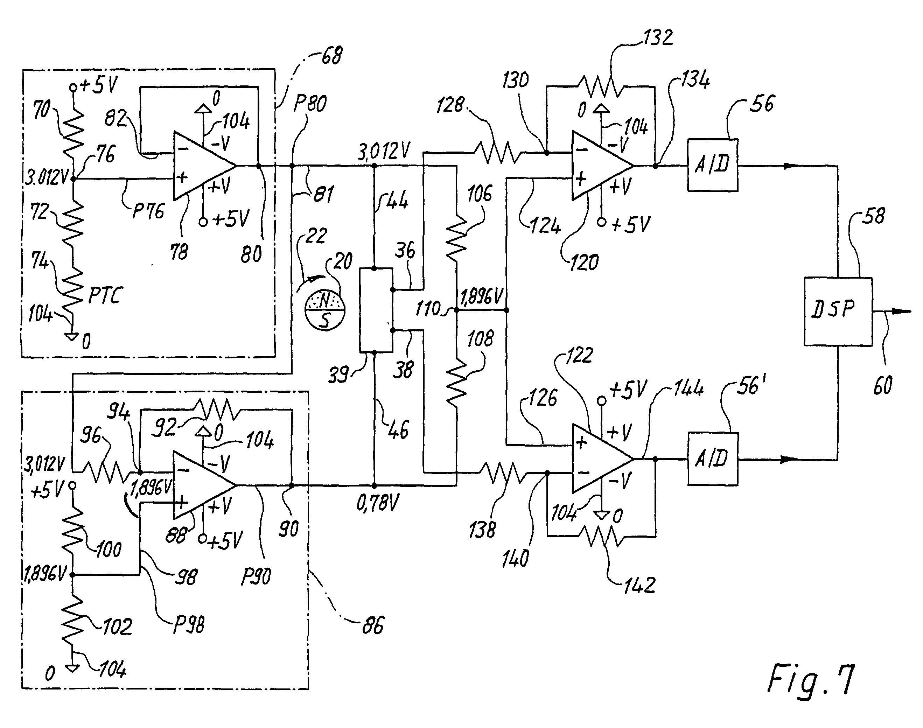

Fig. 7 zeigt eine bevorzugte Ausführungsform einer erfindungsgemäßen Sensoranordnung. Gleiche oder gleichwirkende Teile wie in den vorhergehenden Figuren werden mit denselben Bezugzeichen bezeichnet wie dort und gewöhnlich nicht nochmals beschrieben. Zur Verdeutlichung ist neben dem GMR-Sensor 39 nochmals symbolisch die Magnetscheibe 20 dargestellt. Die eingetragenen Potenziale sind Messwerte, die bei einer Umgebungstemperatur von 25° C gemessen wurden.

Zum Speisen des ersten Eingangs 44 des Sensors 39 ist eine erste Anordnung 68 vorgesehen. Diese hat einen Spannungsteiler mit zwei Festwiderständen 70, 72 und einem PTC-Widerstand 74, der bei 25° C einen Widerstand von 2 kΩ hat.

Wenn der Spannungsteiler aus den Widerständen 70, 72, 74 wie dargestellt an einer konstanten Spannung von + 5 V liegt, ergibt sich bei 25° C an einem Knotenpunkt 76 zwischen den Widerständen 70 (3300 Ohm) und 72 (3000 Ohm) ein Potenzial von

$$p_{76} = 5 \text{ V} * (2000 + 3000)/(2000 + 3000 + 3300) \approx 3 \text{ V} \tag{1}$$

Damit der Spannungsteiler nicht belastet wird, wird dieses Potenzial dem nicht invertierenden Eingang eines Impedanzwandlers 78 zugeführt, an dessen Ausgang 80 also ebenfalls das Potenzial von 3 V liegt. Dieser Ausgang 80 ist über eine Leitung 81 mit dem ersten Eingang 44 des Sensors 39 und mit dem invertierenden Eingang 82 des Verstärkers 78 verbunden.

Wie man ohne weiteres erkennt, steigt das Potenzial $p_{76}$ an, wenn die Temperatur zunimmt, weil der Widerstandswert des PTC-Widerstands 74 mit der Temperatur zunimmt, bevorzugt linear.

Alternativ kann z.B. statt des PTC-Widerstands 74 auch ein NIC 68' verwendet werden, also ein Negative Impedance Converter, wobei sich dann an Stelle der Anordnung 68 der in Fig. 10 dargestellte NIC 68' befindet, der weiter unten beschrieben wird.

Bei 25° C sollte am Sensor 39 eine Betriebsspannung von 2,2 V liegen, d.h. das Potenzial am zweiten Eingang 46 muss bei 25° C einen Wert von 3,0 - 2,2 = 0,8 V haben.

Hierzu ist eine zweite Anordnung 86 vorgesehen. Diese enthält einen Operationsverstärker 88, dessen Ausgang 90 mit dem zweiten Eingang 46 des Sensors 39 verbunden ist. Der Ausgang 90 ist über einen Widerstand 92 mit dem invertierenden Eingang 94 verbunden, der seinerseits über einen Widerstand 96 mit dem Ausgang 80 verbunden ist.

Der nicht invertierende Eingang 98 des Operationsverstärkers 88 ist über einen Widerstand 100 (18 kΩ) mit dem Potenzial + 5 V und über einen Widerstand 102 (11 kΩ) mit Masse 104 verbunden, so dass man am Eingang 98 ein festes Potenzial von

$$p_{98} = 5 \text{ V} * 11/(11 + 18) \approx 1,9 \text{ V} \tag{2}$$

erhält.

Mit den Widerständen 96 (10 kΩ) und 92 (10 kΩ) wird für den invertierenden Eingang 94 ein Verstärkungsfaktor von -1 eingestellt, und diesem Eingang wird über den Widerstand 96 das temperaturabhängige Potenzial $p_{80}$ vom Ausgang 80 zugeführt.

Der Operationsverstärker 88 arbeitet als Differenzverstärker, und das Potenzial $p_{90}$ an seinem Ausgang 90 berechnet sich wie folgt:

$$p_{90} = (1 + 1) * 1{,}9\,V - 1 * p_{80} \tag{3}$$

Bei 25 ° C ist $p_{80}$ = 3 V, und somit ergibt sich

$$p_{90} = 2 * 1{,}9\,V - 3\,V = 0{,}8\,V \tag{4}$$

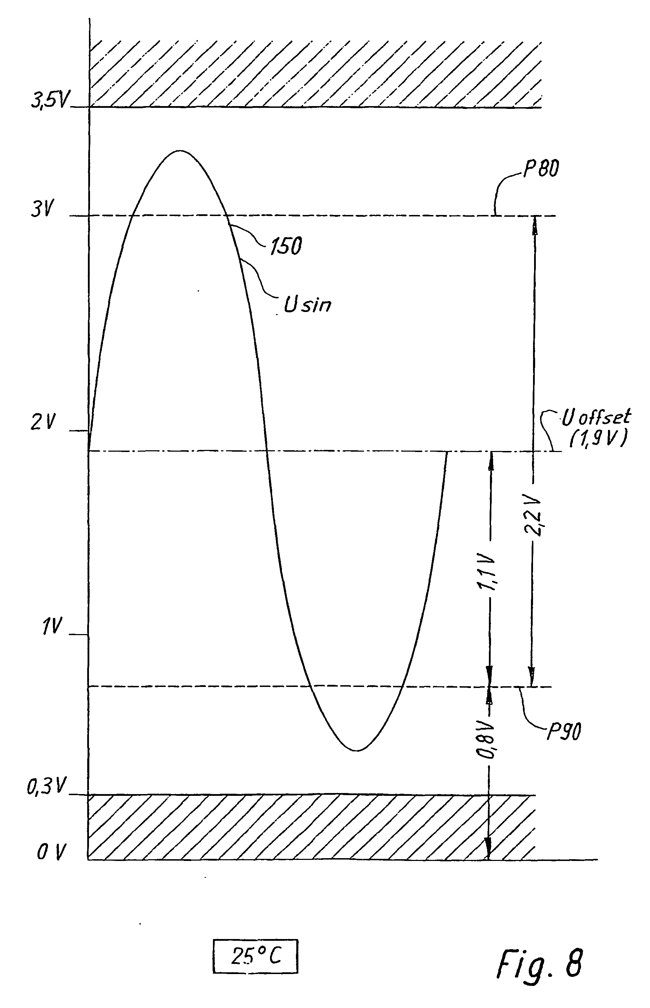

Wie Fig. 8 zeigt, liegt die Betriebsspannung von 2,2 V symmetrisch zu einer Offsetspannung von 1,9 V. Letztere berechnet sich wie folgt:

$$u_{Offset} = ((p_{80} - p_{90})/2) + p_{90} \tag{5}$$

Bei 25° C gilt

$$u_{Offset} = ((3{,}0 - 0{,}8)/2) + 0{,}8 = 1{,}9\,V \tag{6}$$

Zwischen dem ersten Eingang 44 und dem zweiten Eingang 46 liegen zwei identische Widerstände 106, 108 von z.B. je 10 kΩ, und an ihrem Verbindungspunkt 110 kann diese Offsetspannung abgegriffen und als DC-Referenzwert für nachfolgende Verstärker verwendet werden.

Durch Verändern des Verhältnisses der Widerstände 100, 102 kann die Referenzspannung verändert und an einen nachfolgenden A/D-Wandler 56, 56' angepasst werden.

Die Ausgangssignale des Sensors 39 an den Ausgängen 36 und 38 haben z.B., wenn sie einen sinusförmigen Verlauf haben, jeweils einen Signalhub von 50 mV, der symmetrisch zur Offsetspannung von 1,9 V liegt. Dadurch ist es möglich, den Wechselanteil dieser beiden Signale zu verstärken.

### Verhalten bei veränderter Temperatur

Bei - 20° C steigt das Potenzial $p_{90}$ auf etwa 0,95 V, und das Potenzial $p_{80}$ sinkt auf etwa 2,85 V, so dass die Betriebsspannung zwischen den Anschlüssen 44 und 46 auf 1,9 V sinkt. Die Offsetspannung ist gemäß Gleichung (5) weiterhin

$$u_{Offset} = ((2{,}85 - 0{,}95)/2 + 0{,}95 = 1{,}9\,V \tag{7}$$

bleibt also unverändert.

Bei + 100° C sinkt das Potenzial $p_{90}$ auf 0,5 V, und das Potenzial $p_{80}$ steigt auf 3,3 V. Die Betriebsspannung beträgt also bei dieser Temperatur 3,3 - 0,5 = 2,8 V, und die Offsetspannung ist unverändert 1,9 V.

Die Schaltung nach Fig. 7 hat also die Eigenschaft, dass bei der Temperaturkompensation die Offsetspannung unverändert bleibt und bei diesem bevorzugten Beispiel einen Wert von 1,9 V hat, der in der Mitte eines gewünschten Spannungsbereichs von 0,3 V bis 3,5 V liegt, der von den D/A-Wandlern 56, 56' maximal verarbeitet werden kann. Es findet also eine Koordinatentransformation statt, d.h. die horizontale Achse (Zeitachse) des Koordinatensystems wird um 1,9 V in positiver Richtung verschoben.

### Verstärkung der Signale des Sensors 39

Die Ausgangssignale an den beiden Ausgängen 36, 38 haben bei dem Sensortyp GMR_C6, der bei 25° C mit einer Betriebsspannung von 2,2 V betrieben wird, einen Signalhub (peak to peak voltage) von ca. 50 mV. Zweckmäßig für die nachfolgende Verarbeitung ist ein Signalhub von ca. 3 V, d.h. man benötigt eine Verstärkung um den Faktor 60.

Zur Verstärkung dienen zwei Operationsverstärker 120, 122, deren nicht invertierende Eingänge 124 bzw. 126 mit dem Knotenpunkt 110 verbunden sind, also das Offsetpotenzial 1,9 V erhalten.

Über einen Widerstand 128 wird dem invertierenden Eingang 130 des Verstärkers 120 das Signal vom Ausgang 36 zugeführt. Über einen Widerstand 132 ist der Eingang 130 mit dem Ausgang 134 verbunden, an den der A/D-Wandler 56 angeschlossen ist.

Ebenso wird über einen Widerstand 138 das Signal vom Ausgang 38 dem invertierenden Eingang 140 zugeführt. Über einen Widerstand 142 ist der Eingang 140 mit dem Ausgang 144 verbunden, an den der A/D-Wandler 56' angeschlossen ist.

Das Verhältnis der Widerstände 132 (120 kΩ) zu 128 (2 kΩ) bzw. 142 (120 kΩ) zu 138 (2 kΩ) bestimmt den Verstärkungsfaktor, wie folgt

$$V_{120} = R132/R128 = 120/2 = 60 \qquad (8)$$

$$V_{122} = R142/R138 \qquad (9)$$

Da die nicht invertierenden Eingänge 124 bzw. 126 an +1,9 V liegen, liegt die verstärkte Sinusspannung (mit 3 V Signalhub) symmetrisch zu diesem Potenzial von 1,9 V, d.h. sie hat einen Minimalwert von 0,4 V und einen Maximalwert von 3,4 V, wie in Fig. 8 schematisch dargestellt. Dadurch liegt diese Spannung innerhalb des für die Digitalisierung günstigen Bereichs 0,3 ... 3,5 V, so dass eine sichere Signalverarbeitung möglich und in beiden Richtung ein kleiner Sicherheitsabstand vorhanden ist.

Zum Operationsverstärker 88 wird noch folgendes erläutert:
Sein invertierender Verstärker hat eine Verstärkung von

$$V = R\,92/R96 = 10\ k\Omega/10\ k\Omega = 1 \qquad (10)$$

Sein nicht invertierender Verstärker hat eine Verstärkung von

$$V = 1 + R\,92/R\,96 \qquad (11)$$

$$V = 1 + 10/10 = 2$$

**Bevorzugte Liste der Bauelemente in Fig. 7**

| | |
|---|---|
| Operationsverstärker 78, 88, 120, 122 | LM2904/MC |
| Sensor 39 | GMR_C6 |
| PTC-Widerstand 74 | KTY_13_6 |
| R 70 | 3,3 kΩ |
| R 72 | 3 kΩ |
| R 92, 96, 106, 108 | 10 kΩ |
| R 100 | 18 kΩ |
| R 102 | 11 kΩ |
| R 128, 138 | 2 kΩ |
| R 132, 142 | 120 kΩ |

**Fig. 9** zeigt zur Erläuterung die verstärkten Ausgangsspannungen an den Ausgängen 134, 144. Wenn sich die Magnetscheibe 20 mit konstanter Drehzahl dreht, entstehen an diesen Ausgängen zwei sinusförmige Spannungen 150, 152, die um 90° zueinander phasenversetzt sind. Die Amplitude dieser Signale ist im Bereich zwischen - 20° C und + 100° C im wesentlichen konstant, so dass sich die Bilder für diese beiden Temperaturen praktisch nicht unterscheiden. Der Offset um 1,9 V ist in Fig. 9 nicht dargestellt.

**Fig. 10** zeigt eine als NIC bezeichnete Variante 68' zur Anordnung 68 der Fig. 7. Da die übrigen Teile der Schaltung unverändert sind, wird nur der abweichende Teil 68' dargestellt und beschrieben.

Diese Variante 68' hat einen Operationsverstärker 160, dessen invertierender Eingang 162 über einen Widerstand 164 mit einer geregelten Spannung, hier +5 V, verbunden ist. Ferner ist der Eingang 162 über einen Widerstand 166 mit dem Ausgang 168 des Verstärkers 160 verbunden, der seinerseits über einen Widerstand 170 mit dem nicht invertierenden Eingang 172, dem Anschluss 44 des GMR 39, und der Leitung 81 verbunden ist, d.h. am Anschluss 44 erhält man dasselbe Potenzial $p_{80}$ wie in Fig. 7.

**Wirkungsweise**

Wie beschrieben, hat der GMR-Sensor 39 bei 25° C einen Widerstand Ro von 700 Ohm zwischen seinen Anschlüssen 44 und 46. Ro hat Einfluss auf das Potenzial am Eingang 172. Da der Operationsverstärker 160 den Potenzialunterschied zwischen seinen Eingängen 162, 172 auf 0 V regelt, sind die Potenziale an den Eingängen 162, 172 gleich.

Wenn die Temperatur des Sensors 39 ansteigt, steigt sein Widerstand Ro, wodurch der Strom durch ihn sinken und die Amplitude der Signale an seinen Ausgängen 36, 38 (Fig. 7) abnehmen würde. Hierdurch würde das Potenzial $p_{80}$ am Eingang 172 der Fig. 10 sinken. Da jedoch das Potenzial am Eingang 162 konstant ist und da der Verstärker 160 den Potenzialunterschied zwischen seinen Eingängen 162, 172 auf Null regelt, fließt ein höherer Strom vom Ausgang 168 des Verstärkers 160 über den Widerstand 170 zum Sensor 39, wodurch das Potenzial am Eingang 172 entsprechend ansteigt.

Das Zusammenwirken mit der Anordnung 86 wurde bereits bei Fig. 7 beschrieben. Es ist darauf hinzuweisen, dass die Linearität bei der Variante gemäß Fig. 7 besser ist, weil dort ein externer Temperatursensor 74 verwendet wird, z.B. vom Typ KTY 13_6, während bei Fig. 10 der Sensor 39 selbst eine Doppelfunktion als Temperatursensor hat.

**Patentansprüche**

1.  Verfahren zur Temperaturkompensation einer Sensoranordnung (39), welche eine Halb- oder Vollbrückenanordnung aufweist, in der mindestens ein Element (41A, 41B, 43A, 43B) von einer messenden Größe (φ) abhängig ist, um ein von dieser zu messenden Größe abhängiges Ausgangssignal zu erhalten, wobei die Sensoranordnung (39) zur Zuführung einer Speisespannung einen ersten Anschluss (44) und einen zweiten Anschluss (46) aufweist, mit folgenden Schritten:

    a) Wenn sich die Temperatur der Sensoranordnung (39) in einer vorgegebenen Richtung ändert, wird das erste Potenzial (p80) am ersten Anschluss (44) in einem ersten Sinne geändert;
    b) das zweite Potenzial (p90) am zweiten Anschluss (46) wird in diesem Fall in einem zum ersten Sinne entgegengesetzten Sinne geändert;
    c) bezogen auf ein periodisches Ausgangssignal, das einen vorgegebenen Mittelwert (110) aufweist, wird, bezogen auf diesen Mittelwert, die Änderung des ersten Potenzials im wesentlichen um denselben Betrag vorgenommen wie die Änderung des zweiten Potenzials, um eine Temperaturkompensation durch eine Änderung der Speisespannung der Sensoranordnung (39) zu erreichen, welche im wesentlichen symmetrisch zu diesem Mittelwert (110) erfolgt,

    wobei letzterer etwa so eingestellt wird, dass er im wesentlichen einem mittleren Wert der zulässigen analogen Eingangswerte mindestens eines der Sensoranordnung nachgeschalteten A/D-Wandlers (56; 56') entspricht.

2.  Verfahren nach Anspruch 1, bei welchem das Ausgangssignal (Fig. 6: 50) der Sensoranordnung (39) einer Koordinatenverschiebung (Fig. 6: 52) unterzogen wird.

3.  Verfahren nach Anspruch 1 oder 2, bei welchem die Sensoranordnung (39) eine Mehrzahl von temperaturabhängigen Widerständen (41A, 41B, 43A, 43B) aufweist, deren Widerstandswerte temperaturabhängig sind und die als Vollbrückenschaltung (39) geschaltet sind.

4.  Sensoranordnung mit einer als Halb- oder Vollbrückenschaltung ausgebildeten Brückenschaltung (40, 42), welche ein temperaturabhängiges Betriebsverhalten aufweist, welche zu ihrer Speisung mit einer Betriebsspannung einen ersten' Eingang (44) und einen zweiten Eingang (46) aufweist, und welche mindestens einen Ausgang (36, 38) hat, an dem im Betrieb ein von einer zu messenden Größe (phi) abhängiges Ausgangssignal (Vsin, Vcos) auftritt,

mit einer ersten Anordnung (68; 68') zum Erzeugen eines temperaturabhängigen ersten Potenzials (p80), welches das Temperaturverhalten der Brückenschaltung (40, 42) im wesentlichen nachahmt und zum Speisen des ersten Eingangs (44) der Brückenschaltung (40, 42) dient,

und mit einer zweiten Anordnung (86), welche dazu dient, ausgehend von einem im wesentlichen konstanten zweiten Gleichspannungspotenzial (p98) **dadurch** ein drittes Gleichspannungspotenzial (p90) für den zweiten Eingang (46) der Brückenschaltung (40, 42) zu bilden, dass im wesentlichen von einem mit einem vorgegebenen Faktor multiplizierten Wert des zweiten Gleichspannungspotenzials (p98) das temperaturabhängige erste Gleichspannungspotenzial (p80) subtrahiert wird, um so den beiden Eingängen (44, 46) der Brückenschaltung (40, 42) eine temperaturabhängige Speisespannung zuzuführen, welche das mindestens eine Ausgangssignal (Vsin, Vcos) der Brückenschaltung (40, 42) bei einem konstanten Wert der zu messenden Größe (phi) innerhalb eines vorgegebenen Temperaturbereichs im wesentlichen konstant hält,

wobei der Mittelwert der Speisespannung etwa so eingestellt ist, dass er im wesentlichen einem mittleren Wert der zulässigen analogen Eingangswerte mindestens eines der Sensoranordnung nachgeschalteten A/D-Wandlers (56; 56') entspricht.

**5.** Sensoranordnung nach Anspruch 4, bei welcher die erste Anordnung (68) einen ersten Spannungsteiler (70, 72, 74) aufweist, welcher mindestens einen temperaturabhängigen Widerstand (74) aufweist.

**6.** Sensoranordnung nach Anspruch 5, bei welcher ein am ersten Spannungsteiler angeschlossener Verstärker (78) vorgesehen ist, dessen Ausgangspotenzial ($p_{80}$) zur Speisung des ersten Eingangs (44) der Brückenschaltung (40, 42) dient.

**7.** Sensoranordnung nach einem der Ansprüche 4 bis 6, bei welcher zur Erzeugung des dritten Potenzials ($p_{90}$) ein Operationsverstärker (88) vorgesehen ist, der einen Verstärkungsfaktor von im wesentlichen 1 aufweist, dessen nicht invertierendem Eingang (98) das im wesentlichen konstante zweite Gleichspannungspotenzial ($p_{98}$) zugeführt wird, und dessen invertierendem Eingang (94) das temperaturabhängige erste Gleichspannungspotenzial ($p_{80}$) zugeführt wird.

**8.** Sensoranordnung nach einem der Ansprüche 4 bis 7, bei welcher das im wesentlichen konstante zweite Gleichspannungspotenzial (p98) einer vorgegebenen Offsetspannung entspricht.

**9.** Sensoranordnung nach einem der Ansprüche 4 bis 8, bei welcher ein vorgegebenes Offselpotenzial gebildet wird, welches im Bereich zwischen dem Potenzial ($p_{80}$) am ersten Eingang (44) und dem Potenzial (p90) am zweiten Eingang (46) der Brückenschaltung (40, 42) liegt, und bei welchem das mindestens eine Ausgangssignal (Vsin, Vcos) der Brückenschaltung (40, 42) einem Eingang (130; 140) eines Operationsverstärkers (120; 122) zugeführt wird, dessen anderer Eingang (124; 126) an diesem Offsetpotenzial liegt.

**10.** Sensoranordnung nach Anspruch 9, bei welcher das Offsetpotenzial im wesentlichen in der Mitte zwischen dem Potenzial ($p_{80}$) am ersten Eingang (44) und dem Potenzial ($p_{90}$) am zweiten Eingang (46) der Brückenschaltung (40, 42) liegt.

**11.** Sensoranordnung nach Anspruch 9 oder 10, bei welcher die Brückenschaltung (40, 42) zwei Ausgangssignale (Vsin, Vcos) aufweist, jedem dieser beiden Ausgangssignale zu seiner Verstärkung ein Operationsverstärker (120, 122) zugeordnet ist, das betreffende Ausgangssignal (Vsin, Vcos) einem Eingang des zugeordneten Operationsverstärkers zugeführt wird, und dem anderen Eingang des zugeordneten Operationsverstärkers das genannte Offsetpotanzial zugeführt wird.

**12.** Sensoranordnung nach einem der Ansprüche 4 bis 11, bei welcher die Brückenschaltung (40, 42) mit temperaturabhängigem Betriebsverhalten als Teil eines GMR-Sensors (39) ausgebildet ist.

**Claims**

**1.** Method for temperature compensation for a sensor arrangement (39) which comprises a half or full bridge arrangement in which at least one element (41A, 41B, 43A, 43B) is dependent on a variable (φ) to be measured in order to obtain an output signal dependent on this variable to be measured,

wherein the sensor arrangement (39) comprising a first connection (44) and a second connection (46) for supplying a feeding voltage, with the following steps:

a) when the temperature of the sensor arrangement (39) changes in a predetermined direction, the first potential (p80) at the first connection (44) changes in a first direction;

b) in this case the second potential (p90) at the second connection (46) is changed in an opposite direction to the first direction;

c) in relation to a periodic output signal which has a predetermined average value (110), the change in the first potential is made in relation to this average value essentially by the same amount as the change in the second potential in order to obtain temperature compensation by a change in the feeding voltage of the sensor arrangement (39) which essentially takes place symmetrically to this average value (110),

the latter being adjusted so that it essentially corresponds to an average value of the permissible analogue input values of at least one A/D converter (56; 56') connected in series with the sensor arrangement.

2. Method according to claim 1, in which the output signal (Fig. 6: 50) of the sensor arrangement (39) is subjected to a coordinate displacement operation (Fig. 6: 52).

3. Method according to claim 1 or 2, in which the sensor arrangement (39) comprises a plurality of temperature-dependent resistors (41A, 41B, 43A, 43B) the resistance values of which are dependent on the temperature and which are connected in the form of a full bridge circuit (39).

4. Sensor arrangement with a bridge circuit (40, 42) which is embodied as a half or full bridge circuit which comprises a temperature-dependent operating characteristic,

which comprises a first input (44) and a second input (46) for feeding it with an operating voltage,

and which has at least one output (36, 38) at which an output signal (Vsin, Vcos) dependent on a variable (φ) to be measured appears when in operation,

with a first arrangement (68; 68') for producing a temperature-dependent first potential (p80) which essentially emulates the temperature characteristic of the bridge circuit (40, 42) and is used to feed the first input (44) of the bridge circuit (40, 42),

and with a second arrangement (86) which is used, starting from an essentially constant second direct current voltage potential (p98) to form a third direct current voltage potential (p90) for the second input (46) of the bridge circuit (40,42) in that the temperature-dependent first direct current voltage potential (p80) is essentially subtracted from a value of the second direct current voltage potential (p98) multiplied by a predetermined factor in order to supply the two inputs (44, 46) of the bridge circuit (40, 42) with a temperature-dependent feeding voltage which keeps at least one output signal (Vsin, Vcos) of the bridge circuit (40, 42) essentially constant given a constant value of the variable (φ) to be measured within a predetermined temperature range, the average value of the feeding voltage being set roughly so that it essentially corresponds to an average value of the permissible analogue input values of at least one A/D converter (56; 56') connected in series with the sensor arrangement.

5. Sensor arrangement according to claim 4, in which the first arrangement (68) comprises a first voltage divider (70, 72, 74) which comprises at least one temperature-dependent resistor (74).

6. Sensor arrangement according to claim 5, in which an amplifier (78) is provided which is connected to the first voltage divider and the output potential (p80) of which is used to feed the first input (44) of the bridge circuit (40, 42).

7. Sensor arrangement according to one of claims 4 to 6, in which an operation amplifier (88) having a gain of essentially 1 is provided to produce the third potential (p90), the non-inverting input (98) of which is fed the essentially constant second direct current voltage potential (p98), and the inverting input (94) of which is fed the temperature-dependent first direct current voltage potential (p80).

8. Sensor arrangement according to one of claims 4 to 7, in which the essentially constant second direct current voltage potential (p98) corresponds to a predetermined offset voltage.

9. Sensor arrangement according to one of claims 4 to 8, in which a predetermined offset potential is formed which lies in the range between the potential (p80) at the first input (44) and the potential (p90) at the second input (46) of the bridge circuit (40, 42), and in which the at least one output signal (Vsin, Vcos) of the bridge circuit (40,42) is fed to one input (130; 140) of an operation amplifier (120; 122) the other input (124; 126) of which lies at this offset potential.

10. Sensor arrangement according to claim 9, in which the offset potential essentially lies in the middle between the potential (p80) at the first input (44) and the potential (p90) at the second input (46) of the bridge circuit (40, 42).

11. Sensor arrangement according to claim 9 or 10, in which the bridge circuit (40, 42) comprises two output signals (Vsin, Vcos), each of which has an associated operation amplifier (120, 122) for its amplification, the output signal concerned (Vsin, Vcos) is fed to one input of the associated operation amplifier while the named offset potential is fed to the other input of the associated operation amplifier.

12. Sensor arrangement according to one of claims 4 to 11, in which the bridge circuit (40, 42) with the temperature-dependent operating characteristic is embodied as part of a GMR sensor (39).

**Revendications**

1. Procédé de compensation de la température d'un dispositif de détection (39) qui présente un dispositif en pont complet ou en demi-pont dans lequel au moins un élément (41A, 41B, 43A, 43B) dépend d'une grandeur à mesurer (φ) en vue d'obtenir un signal de sortie dépendant de cette grandeur à mesurer,
le dispositif de détection (39) présentant une première connexion (44) et une deuxième connexion (46) pour l'amenée d'une tension d'alimentation, lequel procédé comporte les étapes suivantes :

   a) lorsque la température du dispositif de détection (39) varie dans un sens donné, on fait varier le premier potentiel (p80) à la première connexion (44) dans un premier sens ;
   b) dans ce cas, on fait varier le deuxième potentiel (p90) à la deuxième connexion (46) dans un sens opposé à celui du premier sens ;
   c) par rapport à un signal de sortie périodique qui présente une valeur moyenne donnée (110), on fait varier, par rapport à cette valeur moyenne, le premier potentiel essentiellement de la même valeur que la variation du deuxième potentiel afin d'obtenir une compensation de la température par une variation de la tension d'alimentation du dispositif de détection (39), laquelle a lieu essentiellement symétriquement par rapport à cette valeur moyenne (110),

   cette dernière étant réglée à peu près de manière à correspondre essentiellement à une valeur moyenne des valeurs d'entrée analogiques admissibles d'au moins un convertisseur A/N (56 ; 56') placé en aval du dispositif de détection (39).

2. Procédé selon la revendication 1, dans lequel le signal de sortie (fig. 6 : 50) du dispositif de détection (39) est soumis à un déplacement de coordonnées (fig. 6 : 52).

3. Procédé selon la revendication 1 ou 2, dans lequel le dispositif de détection (39) présente une pluralité de résistances dépendantes de la température (41A, 41B, 43A, 43B) dont les valeurs de résistance dépendent de la température et qui sont montées sous forme de circuit en pont complet.

4. Dispositif de détection avec un circuit en pont (40, 42) réalisé sous forme de demi-pont ou de pont complet,
lequel présente un comportement en service dépendant de la température,
lequel présente une première entrée (44) et une deuxième entrée (46) pour son alimentation avec une tension de service,
et lequel possède au moins une sortie (36, 38) à laquelle apparaît en service un signal de sortie (Vsin, Vcos) dépendant d'une grandeur à mesurer (phi),
avec un premier dispositif (68 ; 68') pour générer un premier potentiel dépendant de la température (p80), lequel reproduit essentiellement le comportement en température du circuit en pont (40, 42) et sert à alimenter la première entrée (44) du circuit en pont (40, 42),
et avec un deuxième dispositif (86) qui sert, partant d'un deuxième potentiel de tension continue essentiellement constant (p98), à former un troisième potentiel de tension continue (p90) pour la deuxième entrée (46) du circuit en pont (40, 42) en soustrayant essentiellement d'une valeur du deuxième potentiel de tension continue (p98) multipliée par un facteur donné le premier potentiel de tension continue dépendant de la température afin d'amener ainsi aux deux entrées (44, 46) du circuit en pont (40, 42) une tension d'alimentation dépendante de la température, laquelle maintient essentiellement constante ledit au moins un signal de sortie (Vsin, Vcos) du circuit en pont (40, 42) dans une plage de température donnée pour une valeur constante de la grandeur à mesurer (phi), la valeur moyenne de la tension d'alimentation étant à peu près réglée de manière à correspondre essentiellement à une valeur moyenne des valeurs d'entrée analogiques admissibles d'au moins un convertisseur A/N (56 ; 56') placé en aval du dispositif de détection.

5. Dispositif de détection selon la revendication 4, dans lequel le premier dispositif (68) présente un premier diviseur de tension (70, 72, 74), lequel présente au moins une résistance dépendante de la température (74).

6. Dispositif de détection selon la revendication 5, dans lequel il est prévu un amplificateur (78) relié au premier diviseur de tension, dont le potentiel de sortie (p80) sert à alimenter la première entrée (44) du circuit en pont (40, 42).

7. Dispositif de détection selon l'une des revendications 4 à 6, dans lequel il est prévu, pour générer le troisième potentiel (p90), un amplificateur opérationnel (88) qui présente un facteur d'amplification essentiellement égal à 1, à l'entrée non inverseuse (98) duquel est amené le deuxième potentiel de tension continue essentiellement constant (p98), et à l'entrée inverseuse (94) duquel est amené le premier potentiel de tension continue dépendant de la température (p80).

8. Dispositif de détection selon l'une des revendications 4 à 7, dans lequel le deuxième potentiel de tension continue essentiellement constant (p98) correspond à une tension d'offset donnée.

9. Dispositif de détection selon l'une des revendications 4 à 8, dans lequel il est formé un potentiel d'offset donné qui se situe dans la plage comprise entre le potentiel (p80) à la première entrée (44) et le potentiel (p90) à la deuxième entrée (46) du circuit en pont (40, 42), et dans lequel ledit au moins un signal de sortie (Vsin, Vcos) du circuit en pont (40, 42) est amené à une entrée (130 ; 140) d'un amplificateur opérationnel (120 ; 122) dont l'autre entrée (124 ; 126) est mise à ce potentiel d'offset.

10. Dispositif de détection selon la revendication 9, dans lequel le potentiel d'offset se situe essentiellement au milieu entre le potentiel (p80) à la première entrée (44) et le potentiel (p90) à la deuxième entrée (46) du circuit en pont (40, 42).

11. Dispositif de détection selon la revendication 9 ou 10, dans lequel le circuit en pont (40, 42) présente deux signaux de sortie (Vsin, Vcos), un amplificateur opérationnel (120 ; 122) est associé à chacun de ces deux signaux de sortie pour son amplification, le signal de sortie (Vsin, Vcos) concerné est amené à une entrée de l'amplificateur opérationnel associé et ledit potentiel d'offset est amené à l'autre entrée de l'amplificateur opérationnel associé.

12. Dispositif de détection selon l'une des revendications 4 à 11, dans lequel le circuit en pont (40, 42) avec comportement en service dépendant de la température est réalisé comme partie d'un capteur GMR (39).

*Fig. 1*

*Fig. 2*

*Fig. 3*

*Fig. 4*

41A
Vsin
36
41B

39
43A
Vcos
42
38
43B

44
40
46

Fig.5

Fig. 6

EP 1 516 159 B1

Fig.7

EP 1 516 159 B1

25°C

Fig. 8

150 (Usin)  152 (Ucos)

t

Fig. 9

68'

166

164

+5V

162

0 104

168

−

+

172

160

+5V

170

81    P80

44

Fig. 10